# EUROPÄISCHE PATENTSCHRIFT

(11) **EP 1 122 685 B1**
(45) Veröffentlichungstag und Bekanntmachung des Hinweises auf die Patenterteilung: **13.08.2008**
(21) Anmeldenummer: 00102073.4
(22) Anmeldetag: 02.02.2000
(51) Int. Cl.: G06K 19/077

(54) **Chipkarte mit Sollbiegestellen**
Chip card with predefined bending locations
Carte à puce avec des points de pliage prédéfinis

(43) Veröffentlichungstag der Anmeldung: 08.08.2001
(73) Patentinhaber: Infineon Technologies AG, 81669 München (DE)
(72) Erfinder: Püschner, Frank, 93309 Kehlheim (DE); Fries, Manfred, 94336 Hunderdorf (DE); Seidl, Annemarie, 93180 Heimberg (DE); Fischer, Jürgen, 93180 Deuerling (DE)
(74) Vertreter: Epping - Hermann - Fischer

(56) Entgegenhaltungen:
- EP-A- 0 716 394
- FR-A- 2 634 095
- US-A- 5 057 460
- PATENT ABSTRACTS OF JAPAN vol. 014, no. 177 (M-0960), 9. April 1990 (1990-04-09) & JP 02 030598 A (DAINIPPON PRINTING CO LTD), 31. Januar 1990 (1990-01-31)

## Beschreibung

Die Erfindung betrifft einen tragbaren Datenträger mit einem kartenförmigen Körper nach dem Oberbegriff des Anspruchs 1.

Derartige tragbare Datenträger sind aus dem Stand der Technik hinlänglich bekannt. So zeigt beispielsweise die EP 0 716 394 ein elektronisches Modul sowie einen Datenträger, bei dem ein kartenförmiger Körper eine Aussparung für ein Chipmodul aufweist. Die US 5,057,460 zeigt ebenfalls ein Chipmodul für den Einsatz in einem Datenträger.

Datenträger werden typischerweise in einer Kartenform (zum Beispiel im Kreditkartenformat) mit eingelagertem integrierten Schaltungsbaustein ausgeführt. Diese Datenträger werden dann als Chipkarten bezeichnet. Datenträger der genannten Art werden im Gebrauch den unterschiedlichsten Belastungen ausgesetzt. Aufgrund der konstruktiven Gegebenheiten mit einem Kartenkörper und einem Chipmodul können hohe Biegebelastungen auf die Anordnung einwirken, die je nach konstruktivem Aufbau zu Ausfällen, verursacht zum Beispiel durch einen Chipbruch oder dem Riß einer elektrischen Verbindung, führen können. Die Anfälligkeit einer derartigen Anordnung ist abhängig von der Chipgröße, von der Länge einer Bonddrahtverbindung zwischen den Kontaktpads eines Halbleiterchips und den verwendeten Materialien.

Ein aus dem Stand der Technik bekanntes Chipmodul weist üblicherweise einen Träger auf, der aus Epoxidharz besteht. Auf einer ersten Hauptseite des Trägers ist ein Halbleiterchip aufgebracht, der beispielsweise mittels kleben oder laminieren mit dem Träger verbunden ist. Auf einer der ersten Hauptseite gegenüberliegenden zweiten Hauptseite des Trägers ist eine Metallisierung aufgebracht. Die Metallisierung weist Kontaktfahnen auf und bildet die später von außen zugänglichen Kontakte des Chipmoduls. Typischerweise weist die Metallisierung sechs oder acht voneinander elektrisch getrennte Kontaktfahnen auf, die jeweils über Bonddrähte mit Kontaktpads des Halbleiterchips verbunden sind. Die Bonddrähte sind dabei durch Ausnehmungen in dem Träger hindurchgeführt. Für einen mechanischen Schutz des Halbleiterchips und der Bonddrähte ist auf der ersten Hauptseite eine Vergußmasse aufgebracht, die den Halbleiterchip und die Bonddrähte umgibt.

Die als nächstliegender Stand der Technik angesehene Druckschrift EP 0716394 (D1) zeigt ebenfalls ein elektronisches Modul sowie einen Datenträger. Dabei ist der Chipträger in Form eines Metallbandes ausgebildet, welcher auf einer Seite mit dem Halbleiterchip versehen ist. Für eine Verbesserung einer mechanischen Entkopplung sind zwischen den einzelnen Kontaktfahnen des Metallbandes zusätzlich Fenster vorgesehen. Die D1 zeigt indes keine Ausnehmungen des Chipträges für eine Kontaktierung der Kontaktfahnen auf der dem Chip gegenüberliegende Seite.

Wird der Datenträger Biegebelastungen ausgesetzt, wie sie zum Beispiel in Briefsortieranlagen beim Versand per Post auftreten, kann dieser beschädigt werden. Konstruktionsbedingt wirkt dort auf den Datenträger in einem Briefkuvert eine hohe kinetische Energie, die einerseits durch eine hohe Geschwindigkeit und andererseits durch häufige Richtungswechsel über bewegliche Rollen der Briefsortieranlage hervorgerufen wird.

Um die auf die Datenträgeranordnung einwirkenden Kräfte möglichst gering zu halten, wurde versucht, die angreifenden Zug- und Druckkräfte entweder durch Erhöhung des Modulbiegewiderstandes im Halbleiterchip und im Bonddrahtbereich durch Verwendung besonders harter Abdeckungen oder durch die Verwendung von Versteifungselementen, zum Beispiel Rahmen auf der ersten Hauptseite des Chipträgers auf die klebende Verbindung zwischen dem Chipmodul und dem kartenförmigen Körper des Datenträgers umzuleiten. Aufgrund der guten praktischen Erfahrungen wurde auf die Verwendung eines sogenannten "HotMelt Klebers" zur Verbindung des Chipmodules mit dem kartenförmigen Körper übergegangen, da dieser sich aufgrund seiner elastischen Eigenschaften als besonders vorteilhaft erwiesen hat.

Nichtsdestotrotz kann es bei hohen Biegebeanspruchungen zu einer Beschädigung des Halbleiterchips oder der Bonddraht-Verbindungen in dem Chipmodul kommen.

Die Aufgabe der vorliegenden Erfindung besteht deshalb darin, eine tragbare Datenträgeranordnung bereitzustellen, die auch bei hohen Biegebeanspruchungen eine hohe Zuverlässigkeit aufweist.

Diese Aufgabe wird mit den Merkmalen des Patentanspruches 1 gelöst.

Die Erfindung geht von der Erkenntnis aus, daß die Durchbiegung des Halbleiterchips beziehungsweise des gesamten Chipmoduls um so kleiner ist, je kleiner die Abmaße des Chipmodules sind. Da die eingangs beschriebenen Chipmodule beziehungsweise tragbaren Datenträgeranordnungen vorgegebenen Normen (ISO-Norm) entsprechen müssen, ist eine beliebige Verkleinerung des Chipmodules jedoch nicht möglich. Die Erfindung sieht deshalb vor, daß der Chipträger Sollbiegestellen aufweist. Da bei auftretenden Biegebeanspruchungen grundsätzlich die schwächste Stelle nachgibt, können durch eine geeignete Anordnung der Sollbiegestellen in dem Chipträger der Halbleiterchip und die elektrischen Verbindungen (Bonddrähte) auf einer biegesteifen Fläche untergebracht werden. Mit anderen Worten sieht die Erfindung also vor, einen steifen Bereich des Chipmoduls derart auszudehnen, daß nicht nur der Halbleiterchip, sondern auch die Drahtbondverbindungen in dem steifen Bereich liegen.

Vorteilhafte Ausgestaltungen ergeben sich aus den Unteransprüchen.

In einer vorteilhaften Ausgestaltung sind die Sollbiegestellen in einem Bereich außerhalb des Halbleiterchips gelegen. Noch vorteilhafter ist es, wenn die Sollbiegestellen außerhalb einer den Halbleiterchip umgebenden Abdeckung angeordnet sind. Wenn die Sollbiegestellen gleichzeitig in einem Bereich innerhalb der Seitenkanten der Ausnehmung gelegen sind, können die auf den tragbaren Datenträger wirkenden Kräfte bestmöglich von dem Halbleiterchip und den elektrischen Verbindungen fern gehalten werden.

In einer Ausgestaltung der Erfindung sind die Sollbiegestellen durch zumindest eine Aussparung in jeder Kontaktfahne der Metallisierung gebildet, wobei die Aussparung die jeweilige Kontaktfahne in einen ersten und in einem zweiten Bereich unterteilt. Die zumindest eine Aussparung in jeder Kontaktfahne schwächt die Metallisierung in diesem Bereich, die den höchsten Biegewiderstand des gesamten Chipmodules aufweist. Der Chipträger selbst, der gegenüber der Metallisierung zwar wesentlich dicker ist, weist einen wesentlich geringeren Biegewiderstand auf. Hierdurch ergibt sich an den Stellen der Aussparung die gewünschte Sollbiegestelle.

Vorteilhafterweise sind der erste und der zweite Bereich durch zumindest einen Steg miteinander verbunden. In diesem Fall ist es möglich, die Kontaktfahnen mittels "Elektro-Plating" ohne Abänderung bestehender Fertigungswerkzeuge oder Fertigungsschnitte zu veredeln, welches ein erprobtes und kostengünstiges Verfahren ist. Würde man die Aussparung der ersten und den zweiten Bereich vollständig voneinander trennen, so müßte eine Veredelung der Kontaktfahnen mittels "Electroless Plating" erfolgen.

Vorteilhafterweise verlaufen die Aussparungen in der Richtung in den jeweiligen Kontaktfahnen, in der die Kontaktfahnen zueinander benachbart liegen. Die Aussparungen benachbarter Kontaktfahnen liegen dabei in einer Achse. Diese Achse liegt im wesentlichen parallel zu den Seitenkanten des Halbleiterchips. Sie führt keinesfalls durch den Halbleiterchip hindurch. In diesem Fall würde ein Durchbrechen des Halbleiterchips begünstigt werden.

Die jeweiligen Stege weisen eine gegenüber der zumindest einen Aussparung wesentlich geringere Breite auf. Durch die Breite des in der Kontaktfahne verbleibenden Steges wird im wesentlichen der Biegewiderstand der Sollbiegestelle bestimmt. Die minimal mögliche Breite des Steges ergibt sich durch die Anforderungen des Elektro-Platings.

Alternativ könnte die Metallisierung auch in einem Bereich innerhalb der Sollbiegestellen enden. Dies bedeutet nichts anderes, als daß der durch die Aussparung gebildete erste Bereich der Kontaktfahne entfällt.

Die Erfindung wird anhand der nachfolgenden Figuren näher erläutert. Es zeigen:
- Figur 1: einen Querschnitt durch den erfindungsgemäßen tragbaren Datenträger gemäß einer ersten Ausführung,
- Figur 2: die Draufsicht auf die Metallisierung des Chipmodules aus Figur 1,
- Figur 3: im Querschnitt ein zweites Ausführungsbeispiel des erfindungsgemäßen tragbaren Datenträgers,
- Figur 4: eine Draufsicht auf eine alternative Ausgestaltungsform der Metallisierung eines Chipmodules und
- Figur 5: einen tragbaren Datenträger, bei dem die Lage der Sollbiegestellen zu dem kartenförmigen Körper ersichtlich wird.

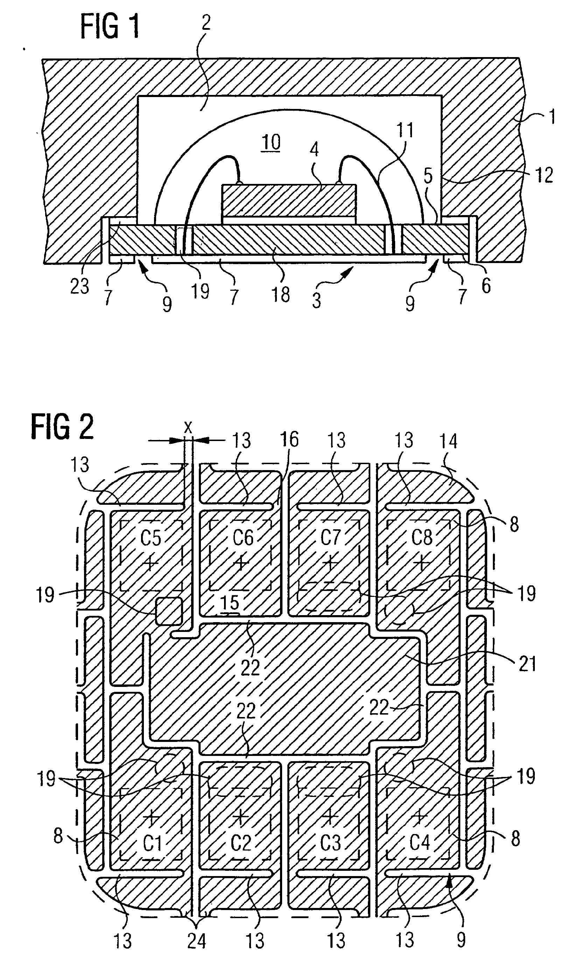

Die Figur 1 zeigt einen Ausschnitt aus einem erfindungsgemäßen tragbaren Datenträger. In einer Ausnehmung 2 eines kartenförmigen Körpers 1 ist ein Chipmodul 3 in bekannter Weise eingebracht. Das Chipmodul 3 besteht aus einem Chipträger 18, auf dessen erster Hauptseite 5 ein Halbleiterchip 4 aufgebracht ist. Auf einer zweiten Hauptseite 6 des Chipträgers 18 ist eine Metallisierung 7 aufgebracht. Die Metallisierung weist eine Mehrzahl an Kontaktfahnen (in dieser Figur nicht ersichtlich) auf, von der jede Kontaktfahne über Bonddrähte 11 mit einem Kontaktpad des Halbleiterchips 4 verbunden ist. Die Bonddrähte 11 sind dabei durch Ausnehmungen 19 durch den Chipträger 18 geführt, um in der Ausnehmung 19 auf die Kontaktfahne zu treffen. Der Halbleiterchip 4 und die Bonddrähte 11 sind weiterhin von einer Abdeckung 10, zum Beispiel einer Plastikvergußmasse umgeben. Das Chipmodul 3 ist an den seitlichen Rändern des Chipträgers über Klebeverbindungen 23 mit dem kartenförmigen Körper 1 verbunden.

Die Klebeverbindung 23 sowie der Chipträger 18, der beispielsweise aus Epoxid besteht, sind aufgrund ihrer Materialien sehr flexibel. Die Metallisierung 7 hingegen, die beispielsweise aus Kupfer besteht, weist jedoch einen hohen Biegewiderstand auf. An den Stellen der Metallisierung, an denen die Metallisierung durchbrochen ist, entstehen somit Sollbiegestellen. Die Sollbiegestellen 9 die somit durch den Chipträger und die besondere Ausgestaltung der Metallisierung gebildet werden, liegen idealerweise außerhalb des Bereichs, in dem sich der Halbleiterchip 4 und die Bonddrähte 11 befinden. Die größtmögliche Wirkung der Sollbiegestellen wird dann erzielt, wenn diese innerhalb der Seitenkanten 12 der Ausnehmung 2 und außerhalb der Abdeckung 10 zum liegen kommen. Die Sollbiegestellen können in diesem Fall die Funktion einer "kardanischen Lagerung" übernehmen. Bei einer auftretenden Biegebeanspruchung knickt der Chipträger an den Sollbiegestellen ab, wobei auf den Halbleiterchip und die Bonddrähte jedoch nur geringe Kräfte übertragen werden, da diese in einem steifen Bereich des Chipmoduls liegen.

Die Figur 2 zeigt eine Draufsicht auf eine Metallisierung 7, durch deren Gestaltung Sollbiegestellen in dem Chipträger erzeugt werden können. Die Metallisierung weist acht Kontaktfahnen 8 auf. Diese sind durch Aussparungen 22 voneinander elektrisch getrennt. In dem mit 21 gekennzeichneten, steifen Bereich befindet sich auf der gegenüberliegenden Hauptseite des Chipträgers (nicht gezeigt) ein Halbleiterchip. Dieser reicht mit seinen Rändern nicht über den mit 21 gekennzeichneten Bereich hinaus. Mit 19 sind die Stellen gekennzeichnet, an denen der nicht gezeigte Chipträger die Ausnehmungen aufweist, durch die Bonddrähte hindurchgeführt und mit den Kontaktfahnen elektrisch verbunden sind. Die rechteckigen Bereiche C1, ... C8 sind die im ISO-Standard 7816 festgelegten Stellen, an denen die Kontaktfahnen von einem externen Schreib-/Lesegerät kontaktiert werden. Die Lage und Größe der Kontaktflächen auf einer Kontaktfahne und ihre Anordnung zueinander ist durch den ISO-Standard genau festgelegt.

Um die bei Biegebeanspruchungen auftretenden Kräfte so gering wie möglich zu halten, könnte die Metallisierung bis zu den durch die ISO-Norm festgelegten Kontaktflächen verkleinert werden. Da die erfindungsgemäßen tragbaren Datenträgeranordnungen jedoch in riesigen Mengen produziert werden, ist eine Abänderung der Verfahrensprozesse sowie eine Änderung der dazu notwendigen Werkzeuge mit außerordentlich hohen Kosten verbunden. Die Erfindung sieht deshalb vor, in die Metallisierung Aussparungen 13 einzubringen, die die Kontaktfahnen 8 jeweils in einen ersten Bereich 14 und einen zweiten Bereich 15 unterteilt. In dem vorliegenden Ausführungsbeispiel sind der erste und der zweite Bereich 14, 15 über schmale Stege 16 miteinander verbunden. Je kleiner der verbleibende Steg 16 ausgeführt wird, desto größer wird die Biegefähigkeit der tragbaren Datenträgeranordnung an den Sollbiegestellen. Die Stegbreite X beträgt idealerweise zwischen 0 und 0,2 mm. Diese Ausgestaltung ist dann vorteilhaft, wenn die Kontaktflächen beziehungsweise Kontaktfahnen mittels Elektro-Plating veredelt werden sollen. Die für das Elektro-Plating notwendigen Elektroden werden außerhalb des in der Figur 7 gezeigten metallisierten Bereichs angebracht. Das Elektro-Plating wird zu einem Zeitpunkt vorgenommen, in dem die Metallisierung mit einer Vielzahl an anderen Metallisierungen für Module auf einem Endlosband liegt. In der Figur 2 sind noch die Trennstellen 24 zu erkennen, mit denen die Metallisierung mit dem (nicht gezeigten) Trägerband verbunden war.

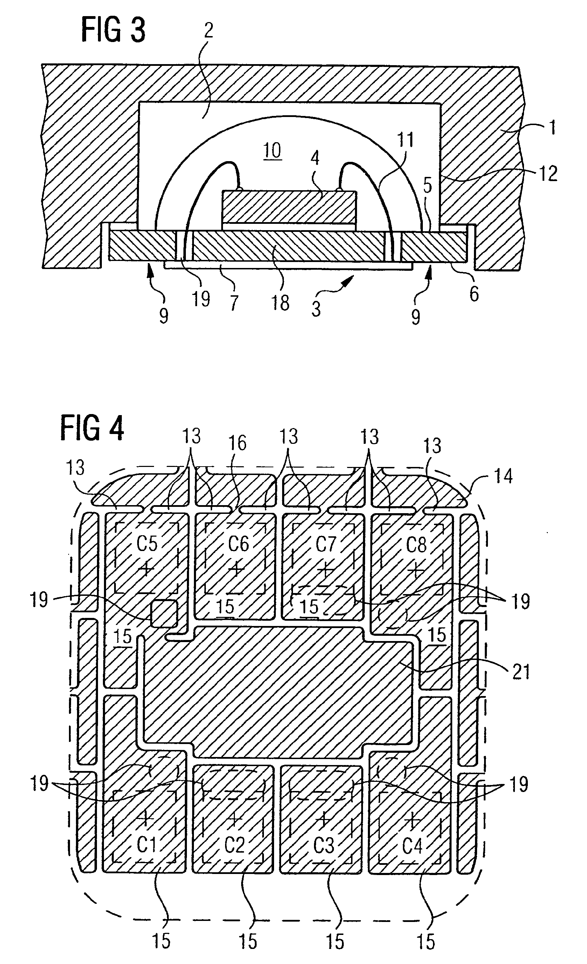

Die Figur 3 zeigt ein zweites Ausführungsbeispiel einer erfindungsgemäßen tragbaren Datenträgeranordnung, die sich von der in Figur 1 gezeigten Anordnung lediglich dadurch unterscheidet, daß die Metallisierung 7 ab den durch die ISO-Norm festgelegten Kontaktflächen C1...C8 vollständig weggelassen ist. Hierdurch entsteht zwischen dem kartenförmigen Körper 1 und der Metallisierung 7 des Chipmoduls 3 eine unebene Fläche. Diese ist zwar aus technischer Sicht nicht von Nachteil, könnte jedoch aus ästhetischen Gründen unerwünscht sein.

In der Figur 4 ist eine Draufsicht auf eine alternativ gestaltete Metallisierung 7 dargestellt, wobei die im oberen Bereich gelegenen Kontaktfahnen 8 jeweils zwei Aussparungen 13 aufweisen, so daß ein Steg 16 in etwa mittig einer jeden Kontaktfahne entsteht. Die Aussparungen 13 der benachbart liegenden Kontaktfahnen sind derart gelegen, daß diese in einer Achse liegen. Diese Achse verläuft in etwa parallel zu der Lage des (nicht gezeigten) Halbleiterchips auf der gegenüberliegenden Hauptseite des Chipträgers. In den gezeigten Ausführungsbeispielen sind die Stege 16 im Verhältnis zur Breite der Kontaktfahnen wesentlich schmäler ausgeführt. Dies muß nicht zwangsläufig der Fall sein, die Stege 16 könnten auch breiter und somit die Aussparungen 13 entsprechend schmäler sein. Durch die Breite der Stege 16 ergibt sich die gewünschte Biegefähigkeit an den erfindungsgemäßen Sollbiegestellen.

Die Figur 4 zeigt in der unteren Hälfte eine weitere Variante, wie die Sollbiegestellen in dem Chipträger erzeugt werden können. In dieser Variante bestehen die Kontaktfahnen 8 lediglich jeweils aus dem zweiten Bereich 15. Der durch die Aussparungen 13 gebildete erste Bereich 14, wie er in der oberen Hälfte dargestellt ist, ist bei den unteren Kontaktfahnen vollständig weggefallen. Hierdurch ergibt sich die oben bereits beschriebene Vertiefung in der Oberfläche der tragbaren Datenträgeranordnung. Diese Variante bietet sich jedoch nur an, sofern das Veredeln der Kontaktflächen auf galvanischem Wege erfolgt. Eine Veredelung mittels Elektro-Plating ist mit den gängigen Werkzeugen dann nicht mehr möglich.

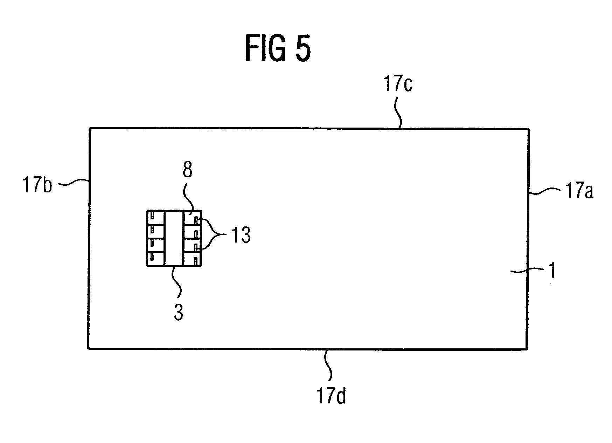

In der Figur 5 ist in der Draufsicht ein erfindungsgemäßer kartenförmiger Körper 1 des tragbaren Datenträgers dargestellt. Der Datenträger weist an der durch den ISO-Standard bestimmten Stelle ein Chipmodul 3 auf, das mit entsprechenden Kontaktfahnen 8 versehen ist. Direkt nebeneinanderliegende Kontaktfahnen 8 bilden eine Achse, die parallel zu den kurzen Seitenkanten 17a, 17b des kartenförmigen Körpers liegt. Die in die Kontaktfahnen 8 eingebrachten Aussparungen 13 liegen ebenfalls in einer Achse, die parallel zu den kurzen Seitenkanten 17a, 17b des kartenförmigen Körpers liegt. Dies ist dadurch bedingt, daß die kritischste Biegebeanspruchung parallel zu den langen Seitenkanten 17c, 17d des kartenförmigen Körpers 1 verläuft.

Die Biegebeanspruchungen auf einen Halbleiterchip und Drahtverbindungen können durch das Vorsehen von Sollbiegestellen in einem Chipträger eines Chipmodules verringert werden. Die Sollbiegestellen werden durch ein spezielles Layout der auf dem Chipträger aufgebrachten Metallisierung unter Beachtung der ISO 7816-Norm erzeugt. Hierdurch ist es möglich, auf die üblichen Versteifungselemente zu verzichten, wodurch Kosten eingespart werden können.

### Bezugszeichenliste

- 1: Kartenförmiger Körper
- 2: Ausnehmung
- 3: Chipmodul
- 4: Halbleiterchip
- 5: Erste Hauptseite
- 6: Zweite Hauptseite
- 7: Metallisierung
- 8: Kontaktfahne
- 9: Sollbiegestelle
- 10: Abdeckung
- 11: Bonddraht
- 12: Seitenkante
- 13: Aussparung
- 14: Erster Bereich
- 15: Zweiter Bereich
- 16: Steg
- 17 a, b c, d: kurze Seite lange Seite
- 18: Chipträger
- 19: Ausnehmung
- 21: Bereich
- 22: Aussparung
- 23: Klebeverbindung
- 24: Trennstelle
- x: Stegbreite
- C1...C8: Kontaktfläche

## Patentansprüche

1. Tragbarer Datenträger mit einem kartenförmigen Körper (1), der eine Ausnehmung (2) zur Aufnahme eines Chipmoduls (3) aufweist, wobei das Chipmodul (3) zumindest einen Halbleiterchip (4) aufweist, wobei
das Chipmodul (3) einen mit dem kartenförmigen Körper (1) verbundenen Chipträger (18) mit dem Halbleiterchip (4) auf einer ersten Hauptseite (5) und mit einer Kontaktfahnen (8) aufweisende Metallisierung (7) auf einer zweiten Hauptseite (6) des Chipträgers (18) beinhaltet,
**dadurch gekennzeichnet, dass** der Chipträger (18) Ausnehmungen (19) aufweist, durch die die Kontaktfahnen (3) kontaktiert werden und dass der Chipträger (16) Sollbiegestellen (9) in Form einer durchbrochenen Metallisierung aufweist, die in einem Bereich innerhalb der Seitenkanten (12) der Ausnehmung (2) zur Aufnahme des Chipmoduls (3) gelegen sind.

2. Tragbarer Datenträger nach Anspruch 1,
**dadurch gekennzeichnet,**
**daß** die Sollbiegestellen (9) in einem Bereich außerhalb des Halbleiterchips (4) gelegen sind.

3. Tragbarer Datenträger nach Anspruch 1 oder 2,
**dadurch gekennzeichnet,**
**daß** die Sollbiegestellen (9) außerhalb einer den Halbleiterchip (4) umgebenden Abdeckung (10) gelegen sind.

4. Tragbarer Datenträger nach einem der Ansprüche 1 bis 3,
**dadurch gekennzeichnet,**
**daß** die Sollbiegestellen (9) durch zumindest eine Aussparung (13) in jeder Kontaktfahne (8) gebildet sind, die die jeweilige Kontaktfahne (8) in einen ersten und einen zweiten Bereich (14, 15) unterteilt.

5. Tragbarer Datenträger nach Anspruch 4,
**dadurch gekennzeichnet,**
**daß** der erste und der zweite Bereich (14, 15) durch zumindest einen Steg miteinander verbunden sind.

6. Tragbarer Datenträger nach Anspruch 4 oder 5,
**dadurch gekennzeichnet,**
**daß** die Aussparungen (13) in der Richtung verlaufen, in der die Kontaktfahnen (8) zueinander benachbart liegen.

7. Tragbarer Datenträger nach einem der Ansprüche 4 bis 6,
**dadurch gekennzeichnet,**
**daß** die Stege (16) eine gegenüber der zumindest einen Aussparung (13) wesentlich geringere Breite aufweisen.

8. Tragbarer Datenträger nach einem der Ansprüche 1 bis 3,
**dadurch gekennzeichnet,**
**daß** die Metallisierung (7) in einem Bereich innerhalb der Sollbiegestellen (9) endet.

## Claims

1. Portable data carrier having a card-type body (1), which has a recess (2) for receiving a chip module (3), the chip module (3) having at least one semiconductor chip (4), the chip module (3) comprising a chip carrier (18), connected to the card-type body (1), with the semiconductor chip (4) on a first main side (5) and with a metallization layer (7) having contact lugs (8) on a second main side (6) of the chip carrier (18),
**characterized**
**in that** the chip carrier (18) has recesses (19), through which the contact lugs (3) are contact-connected, and in that the chip carrier (16) has desired bending points (9) in the form of a perforated metallization, which are located in a region within the side edges (12) of the recess (2) for receiving the chip module (3).

2. Portable data carrier according to Claim 1,
**characterized**
**in that** the desired bending points (9) are located in a region outside the semiconductor chip (4).

3. Portable data carrier according to Claim 1 or 2,
**characterized**
**in that** the desired bending points (9) are located outside a covering (10) surrounding the semiconductor chip (4).

4. Portable data carrier according to one of Claims 1 to 3,
**characterized**
**in that** the desired bending points (9) are formed by at least one cutout (13) in each contact lug (8) which subdivides the respective contact lug (8) into a first and a second region (14, 15).

5. Portable data carrier according to Claim 4,
**characterized**
**in that** the first and second regions (14, 15) are connected to one another by at least one web.

6. Portable data carrier according to Claim 4 or 5,
**characterized**
**in that** the cutouts (13) run in the direction in which the contact lugs (8) lie adjacent to one another.

7. Portable data carrier according to one of Claims 4 to 6,
**characterized**
**in that** the webs (16) have a significantly smaller width than the at least one cutout (13).

8. Portable data carrier according to one of Claims 1 to 3,
**characterized**
**in that** the metallization layer (7) ends in a region within the desired bending points (9).

## Revendications

1. Support de données portatif, comprenant un corps (1) en forme de carte, qui a un creux (2) de réception d'un module (3) de puce, le module (3) de puce ayant au moins une puce (4) à semi-conducteur, dans lequel
le module (3) de puce comporte un support (18) de puce, relié au corps (1) en forme de carte et ayant la puce (4) à semi-conducteur sur un premier côté (5) principal et une métallisation (7) ayant des plages (8) de contact sur un deuxième côté (6) principal du support (18) de puce,
**caractérisé en ce que** le support (18) de puce a des creux (19) par lesquels les plages (3) de contact peuvent être mises en contact, et **en ce que** le support (16) de puce a des emplacements (9) destinés à être pliés sous la forme d'une métallisation interrompue, qui sont mis dans une partie à l'intérieur des bords (12) latéraux du creux (2) de réception du module (3) de puce.

2. Support de données portatif suivant la revendication 1,
**caractérisé**
**en ce que** les emplacements (9) destinés à être pliés sont mis dans une partie à l'extérieur de la puce (4) à semi-conducteur.

3. Support de données portatif suivant la revendication 1 ou 2,
**caractérisé**
**en ce que** les emplacements (9) destinés à être pliés sont mis à l'extérieur d'un recouvrement (10) entourant la puce (4) à semi-conducteur.

4. Support de données portatif suivant l'une des revendications 1 à 3,
**caractérisé**
**en ce que** les emplacements (9) destinés à être pliés sont formés par au moins un enlèvement (13) de matière dans chaque plage (8) de contact, qui subdivise la plage (8) de contact respective en une première et en une deuxième partie (14, 15).

5. Support de données portatif suivant la revendication 4,
**caractérisé**
**en ce que** la première et la deuxième partie (14, 15) sont reliées par au moins une partie pleine.

6. Support de données portatif suivant la revendication 4 ou 5,
**caractérisé**
**en ce que** les évidements (13) s'étendent dans la direction dans laquelle les plages (8) de contact sont voisines les unes des autres.

7. Support de données portatif suivant l'une des revendications 4 à 6,
**caractérisé**
**en ce que** les parties pleines (16) ont une largeur plus petite que le au moins un évidement (13) de matière.

8. Support de données portatif suivant l'une des revendications 1 à 3,
**caractérisé**
**en ce que** la métallisation (7) se termine dans une partie au sein de l'emplacement (9) destiné à être plié.
